# EUROPEAN PATENT SPECIFICATION

(11) **EP 1 401 098 B1**
(45) Date of publication and mention of the grant of the patent: **15.10.2008**
(21) Application number: 02020648.8
(22) Date of filing: 13.09.2002
(51) Int. Cl.: H03G 3/30

(54) **Method and system for power control in radio transceivers and transmitters**
Verfahren und System zur Leistungsregelung in Senderempfängern und in Sendern
Méthode et système de contrôle de puissance pour émetteurs-récepteurs et pour transmetteurs

(30) Priority: 11.09.2002 EP 02020320
(43) Date of publication of application: 24.03.2004
(73) Proprietor: Palm, Inc., Sunnyvale, CA 94085-2801 (US)
(72) Inventor: Gentsch, Morten Brok, DK-9000 Aalborg (DK); Henningsen, Hans Christian, DK-9493 Saltum (DK); Moller-Jensen, Bjarne, DK-9000 Aalborg (DK); Wolfsen, Peer, DK-9400 Norresundby (DK)
(74) Representative: W.P. Thompson & Co.

(56) References cited:
- WO-A-01/50632
- WO-A-01/84741

## Description

### Field of the invention

The invention relates generally to power control in a radio transmitter. More specifically, the invention relates to power control in situations where some environmental conditions influencing the transmitter or some other system characteristics change.

### Background of the invention

Mobile terminals used in mobile networks have to comply with the power level instructions received from the network. For example, in the specification 3GPP TS 45.005 (Third Generation Partnership Project; Technical Specification Group; GSM/EDGE Radio Access Network: Radio Transmission and Reception), some power levels for mobile terminals in different Global System for Mobile Communications GSM and Enhanced Data rates for GSM Evolution EDGE mobile networks are disclosed.

The mobile network monitors the output power level of a cellular telephone within the network coverage. The mobile network transmits power level setting commands to the mobile terminals which need to obey the power level setting commands received. This is important especially for minimising the amount of inter-cell interference so that channel capacity can be maximised.

In order for the mobile terminals to effectively control the transmitted power and thus to avoid deteriorating the efficiency of the mobile network, the mobile terminals need to comprise a power control system for their radio transmitters.

Software power control is favourable to a power control system realised with circuit board electronics, because a power loop system easily consumes lots of space on the circuit board.

A modern output power control system of a transmitter has been disclosed in the international patent application WO 01/84741 A2. The patent publication discloses a software power control system that can take into account fluctuations of the output power level, frequency fluctuations of the transmitter, and fluctuations of the supply voltage.

As disclosed in the '741, the calibration of the power control system can be implemented using software so that data identifying calibration points are stored into memory. This data corresponds to frequency and output power control values, for example. The data identifying the calibration is then used when actually correcting the power control system.

The problem related with any stored power control calibration is that if some characteristic of a system component changes, this change may induce some additional error not taken into account in the original calibration. For example, if the antenna impedance changes due to changing antenna near-field environments, or if the temperature of the mobile terminal changes, or if the power supply of the mobile terminal is changed, the previously stored calibration may be faulty.

Using such a calibration leads to errors in the power control procedure.

A similar solution to '741 can be implemented using hardware circuit as presented in UK patent application GB 2292276 A. In the '276 application, predetermined values are stored and used so that a particular transmission level is output for each time slot. A comparator in the system compares the transmission level actually detected by the level detector in each time slot against the corresponding pre-selected value. A level adjusting circuit then corrects the pre-selected value on the basis of the output of the comparator, for example by adding a small value to the pre-selected value. This correction is used in the transmitter. Alternatively, to correct the control data the correction value may be directly calculated or otherwise produced from the previously stated deviation instead of the small increment or decrement by the predetermined value.

Obviously, the solution presented in '276 does not help either in constructing such a system that is not only cheap to produce but also provides the mobile terminal and especially its transmitter with a power control system that is invariant to changes in the terminal characteristics that occur after the manufacturing step.

A system and a method according to the preamble parts of claims 1 and 6, respectively, are known from international patent application WO 01/50632 A1. An adaptation of the correction parameter (denoted as correction value in WO 01/50632 A1) is only achieved on a burst to burst basis, so that there is the danger of erratic changes of the correction parameter.

It is an object of the invention to obtain a solution by means of which it is possible to alleviate or eliminate at least some of the drawbacks in the radio transmitter power control systems and methods of the prior art. In particular the invention aims to achieve smooth changes of the correction parameter, allowing a proper self-learning adaptation of the up- and down-ramp shapes used for the transmission of the input signal.

### Summary of the invention

This and other objectives of the invention are achieved by the system defined in claim 1 and by the method defined in claim 6. According to the invention history data describing relations between power levels and up- and down-ramp shapes are collected and used for the adaptation of the correction parameter, so said erratic changes of the correction parameter can be avoided.

### Brief Description of the Drawings

In the following, the invention and its preferred embodiments are described more closely referring to the examples shown in Figures 1 to 7 in the appended drawings, wherein
- Figure 1: illustrates the controlling system of the up- and down-ramp of the radio transmitter,
- Figure 2: illustrates the adaptive power control system, which adjusts the power control performed in the system of Figure 1,
- Figure 3: is a flow diagram illustrating the main part in which the power control of the system shown in Figure 1 is performed,
- Figure 4: illustrates the principle with which the adaptive power control system of Figure 2 works,
- Figure 5: illustrates a data burst showing how the reference value PA_{DAC},_{MAX} can be obtained,
- Figure 6: illustrates how a power correction value can be obtained, and
- Figure 7: shows the detected power level P_{A} changes at down- or up-ramp positions for GMSK and 8-PSK modulations.

Like reference numbers denote similar items throughout the figures.

### Detailed description of the invention

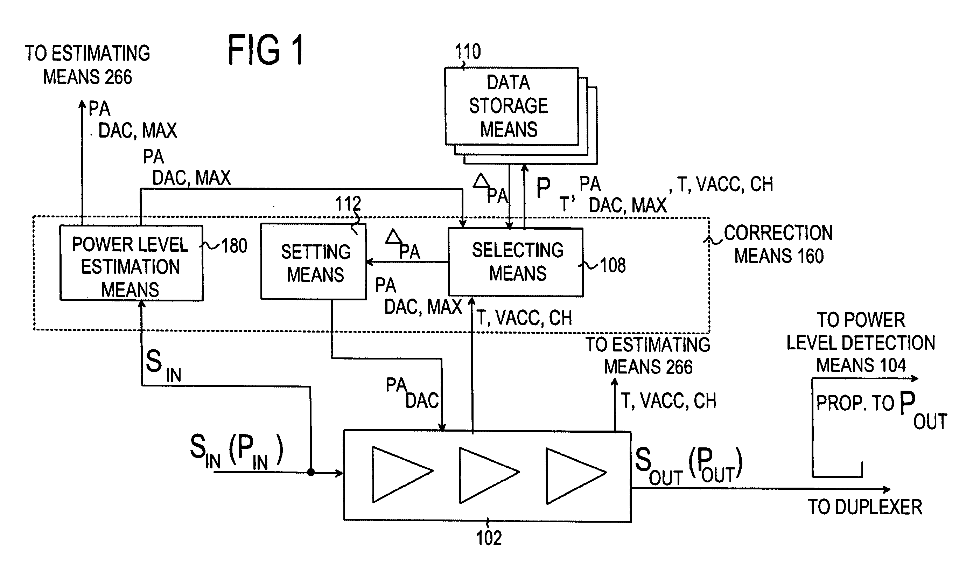

Figure 1 illustrates the actual power control system in accordance with an aspect of the present invention. The transmitter 102 amplifies an input signal S_{IN} which originally has power PIN to an output signal S_{OUT} having power P_{OUT}·

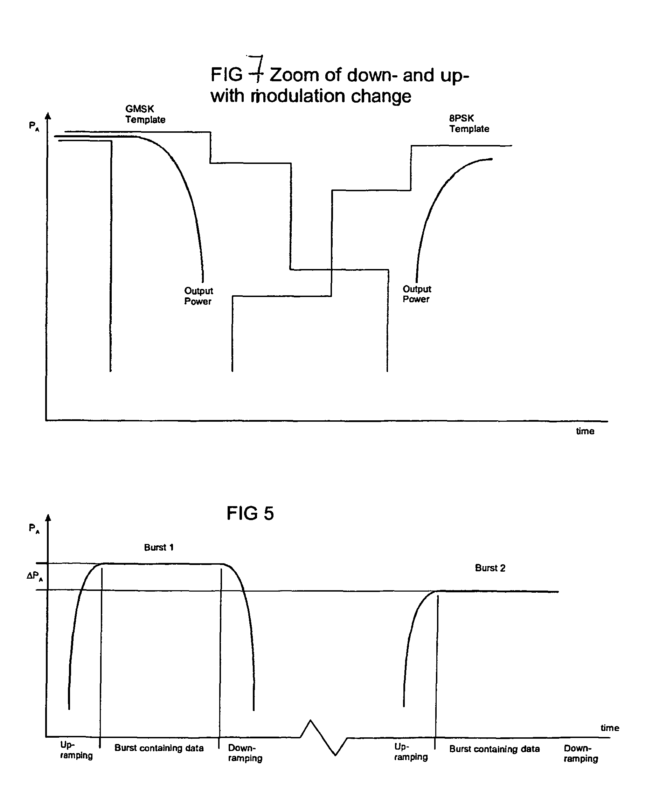

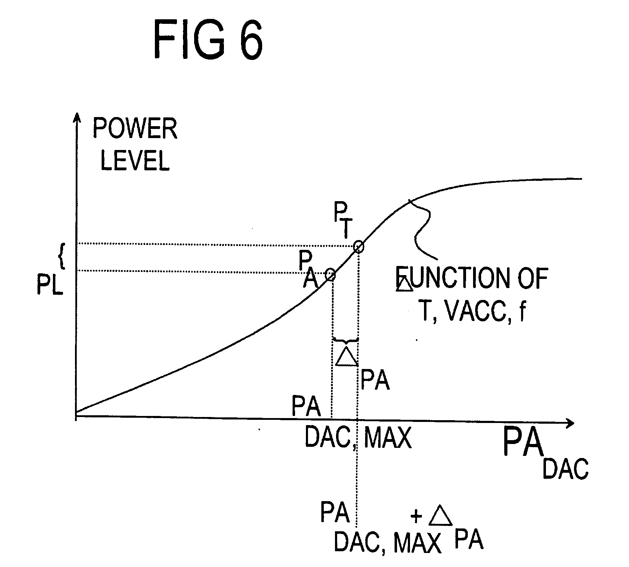

The nature of the input signal S_{IN} to be transmitted, as well as conceptualisation of the different power levels extensively used in the description of the invention are shortly characterised with reference to Figures 5 and 6.

Figure 5 is a schematic diagram of two data bursts. The up ramp or up-ramping shape corresponds to a leading edge of the data burst at this point in the transmitter 102 the carrier signal is being transmitted. Correspondingly, when the transmission carrier signal of data burst ends as this is called down ramp or down-ramping. The maximum value of the up- and down-ramp defined correspond or can be scaled to fit to the maximum output power of the data burst sent by the transmitter 102. In the example of Figure 5 the maximum estimated power level PA_{DAC},_{MAX} is obtained from the maximum value of this down ramp stage. Because data may be included in the bursts, therefore having an effect to the detected power level P_{A}, the detected power levels between the two bursts may differ even ΔP_{A} still having acceptable values.

Figure 6 illustrates the imperfections of a normal environmental effect changing system typically used in a transmitter. The erroneous corrections can effect the power level P_{OUT} with which an input signal S_{IN} is going to be transmitted, if the imperfections are not corrected. Such imperfections may arise from a single component's sensitivity changes in the channel frequency CH, supply voltage VACC, or temperature T. The maximum estimated power level PA_{DAC},_{MAX} corresponds ordinarily to the actual power level i.e. to the output power of the power amplifier or transmitter.

If the detected power level P_{A} is smaller than the target power level P_{T} by the amount of the comparison result Δ_{PL}, the up- and down-ramp shape PA_{DAC} has to be corrected by the correction parameter Δ_{PA}. As seen in the Figure 6, the target output power level P_{T} corresponding to the up- and down-ramp for PA_{DAC},_{MAX} + Δ_{PA} corresponds to the target power level P_{T}, but only if the correction parameter Δ_{PA} is correct. Because the correction parameters Δ_{PA} can, according to the invention, change during the lifetime of the device wherein the inventive method and/or system is implemented, the target power level can be reached more accurately and faster, thus enhancing the overall system performance.

Now referring back to Figure 1; the output power P_{OUT} of the signal S_{OUT} needs to be corrected so that the detected power level P_{A} corresponds to the target power level P_{T}. For this purpose the power control system includes also correction means 160 that select the correction parameter Δ_{PA} from data storage 110 with which the operation of the transmitter 102 is modified.

In the following the functionality of an example configuration of the correction means 160 is closer illustrated, wherein the correction means 160 include selecting means 108, setting means 112 and power level estimating means 180.

The estimated maximum power level PA_{DAC,MAX} is estimated from the temperature, supply voltage and the frequency and maybe the input signal S_{IN} in the power level estimating means 180. The estimated maximum power level PA_{DAC,MAX} is passed to selecting means 108. The selecting means 108 obtain also data representing temperature T, supply voltage VACC, and channel frequency CH, for example, from the transmitter 102.

On the basis of the estimated maximum power level PA_{DAC,MAX}, temperature T, supply voltage VACC, and channel frequency CH, the selecting means 108 request a correction parameter Δ_{PA} from the data storage 110. In the data storage 110 there are stored values corresponding to correction parameters Δ_{PA} in respect with the plurality of combinations of the estimated power level PA_{DAC,MAX}, temperature T, supply voltage VACC and channel CH.

The data storage 110 returns the correction parameter Δ_{PA} corresponding to the combination of parameters included in the request. The selecting means 108 pass the obtained correction parameter Δ_{PA} together with the maximum estimated power level PA_{DAC,MAX} to the setting means 112. The setting means 112 perform the actual power control of the transmitter 102 by first calculating and then setting the up- and down-ramp shape PA_{DAC} to the transmitter 102. In order to minimise switching transients, the shape of the up- and down-ramp should be as close as possible to a raised cosine function.

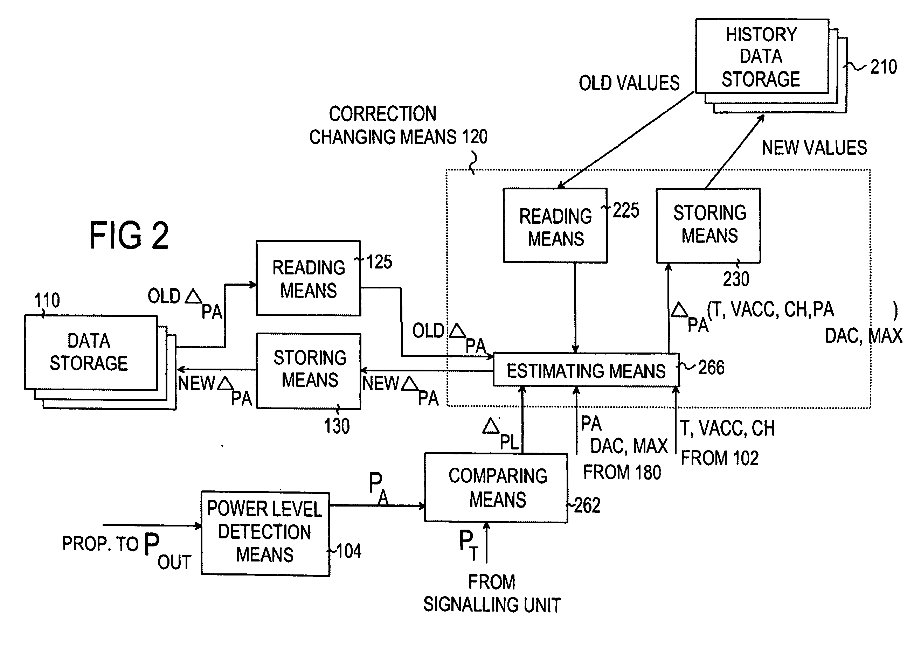

Figure 2 illustrates how the power control system in accordance with the present invention includes correction changing means 120 for adjusting the correction parameters Δ_{PA} stored into the data storage 110. The correction changing means 120 include reading means 225, storing means 230, and estimating means 266. Further, a history data storage 210 for storing old correction values may be interpreted to belong to the correction changing means 120 as well. The comparing means 262 receive a target power level P_{T} from the signalling unit if the device is a mobile terminal or base station.

The target power level P_{T} is often dictated by the network in which the phone operates. The target power level P_{T} is compared in the comparing means 262 with a detected power level P_{A} obtained from the power level detection means 104 which, for example, produces a voltage in proportion to the output power P_{OUT} of the output signal S_{OUT}. The reference value can be obtained using a coupler, for example. The comparing means 262 calculate a comparison result Δ_{PL}, for example, by subtracting target power level P_{T} from the detected power level P_{A}. The comparison result Δ_{PL} is sent to the estimating means 266.

The estimating means 266 obtain also the maximum estimated power level P_{ADAC,MAX} from the power level estimating means 180. Further, the estimating means 266 obtain values of at least one of the following parameters from the transmitter 102: temperature T, supply voltage VACC, channel frequency CH.

The estimating means 266 are responsive to the comparing means 262 in the sense that they are adapted to estimate a new correction parameter NEW Δ_{PA} if the result of the comparison shows that the detected power level P_{A} differs from the target power level P_{T} more than a predetermined threshold value, that is, if the absolute value of Δ_{PL} is smaller or larger than the predetermined threshold value. This kind of situation means that the old correction parameters are faulty, and using such parameters leads to an erroneous power control of the transmitter.

The new correction parameter NEW Δ_{PA} is stored into the data storage 110 by the storing means 130 which obtain the new correction parameter NEW Δ_{PA} from the estimating means 266.

Further, the system of Figure 2 includes reading means 125 for reading a stored correction parameter OLD Δ_{PA} from the data storage 110 and then passing it to the estimating means 266. The estimating means may be adapted to calculate the new correction parameter NEW Δ_{PA} based on the value of the old correction parameter OLD Δ_{PA} and the comparison results Δ_{PL} between the target power level P_{T} and the detected power level P_{L}. The purpose of this procedure is to make the system a self-learning; i.e. when the old values are used as a basis for the estimation, the probability that the new the correction parameter NEW Δ_{PA} is not too far from the right value already for the first iteration and that statistical variations of the observations are not interpreted in a misleadingly way. This enhances the system performance, especially when the effect of the characteristic changes in the component characteristics, are minor. All the default values for power control can be downloaded into data storage 110 in the production. No power adjustments are really needed as long as the characteristics of the power detector are known. This makes the power control self-learning.

The system further includes reading means 225 for reading values describing the relationship between the power level PL and the up- and down-ramp PA_{DAC} from a history data storage 210. The estimating means 266 are adapted to use also the values read for calculating the new correction parameter NEW Δ_{PA·}

The system further includes storing means 230 that are adapted to store values describing such relationship between the correction parameter Δ_{PL,} and the target power level PT and the up- and down-ramp shape PA_{DAC} into the history data storage 210. It is also possible only to store a few ramps and then scale them to fit the corrected output power.

The history data storage 210 sends the old values describing the relationship between the output power level and the up- and down-ramp PA_{DAC} for a specific parameter or parameters such as temperature T, supply voltage VACC, or channel frequency CH. These parameters are read from the history data storage 210 by the reading means 225 which further pass them to the estimating means 266. The estimating means 266 further pass similar relationship data (see the curve of Figure 6) describing the detected power level P_{A} and the up- and down-ramp PA_{DAC} to the storing means 230 which store the data into the history data storage 210. The parameters may as well be generated with an arbitrary combination of parameters T, VACC, CH. Thus a curve family is formed.

The estimating means 266 use the old correction parameters OLD Δ_{PA} read from data storage 110 by the reading means 125 for computing a new correction parameter NEW Δ_{PA}. Correspondingly, the estimating means 266 may save new correction parameters NEW Δ_{PA} with the help of storing means 130 to the data storage 110.

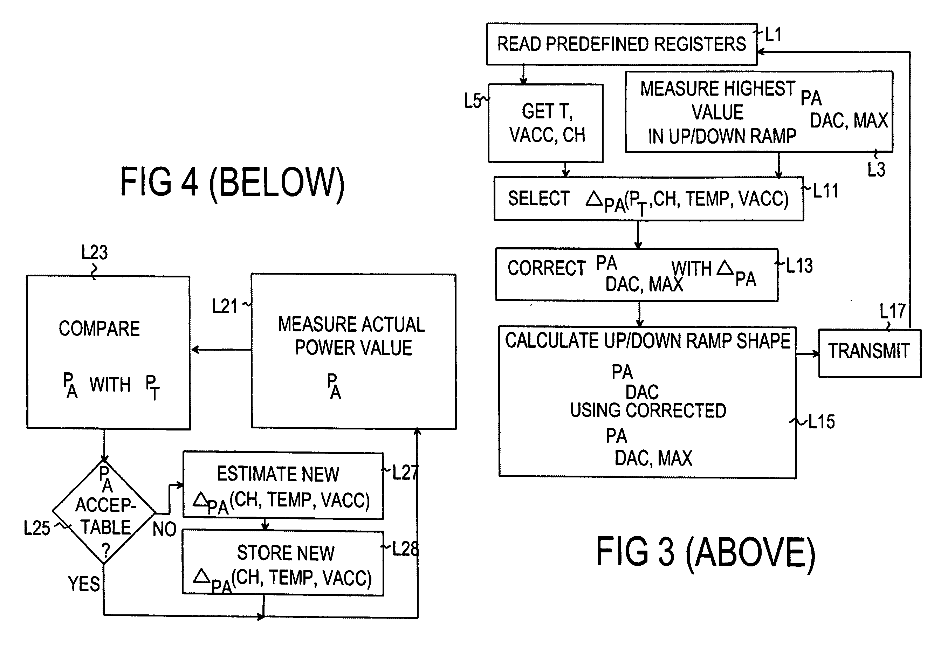

Figure 3 is a flow diagram showing some steps used in the power control system and method presented in Figure 1. In step L1 predefined registers containing data about the system information, such as the contents of the data storage 110, are read. The reading step L1 may be performed by the selecting means 108, setting means 112, or there may be a separate software block wherein the registers are read.

In step L3 the power level detection means 104 could measure the highest value of the input signal S_{IN} at the up- and down-ramp position thus obtaining a value corresponding to the maximum estimated power level PA_{DAC,MAX}. The power can as well be measured in average over a short time in the data burst, depending on the modulation used in the system.

In step L5 the values of temperature T, supply voltage VACC, and channel frequency CH are received by the selecting means 108 from the transmitter 102 or from the signalling unit.

The correction parameter Δ_{PA} is a function of the channel frequency CH, temperature T, supply voltage VACC, and the highest value in the up- and down-ramp shape PA_{DAC,MAX} and the target power level P_{T} such as the Δ_{PA} = Δ_{PA} (P_{T}, PA_{DAC}, T, V_{ACC}, CH), defined for the range of parameters.

In step L11 the correction parameter Δ_{PA} corresponding to the channel frequency CH, temperature T, supply voltage VACC, and the highest value in the up- and down-ramp, i.e. maximum estimated power level PA_{DAC,MAX} is selected in the selecting means 108. The selecting means 108 requests the detected power level value P_{A} from the data storage 110 by sending a request for the highest value in the up- and down-ramp PA_{DAC,MAX}, temperature T, supply voltage VACC, and channel frequency CH. The data storage 110 responds by returning the correction parameter Δ_{PA} to the selecting means 108. The selecting means 108 then send the value of Δ_{PA} to the setting means 112 which in the step L13 correct the highest value of the up- and down-ramp PA_{DAC,MAX} with the correction parameter Δ_{PA} and then calculate in step L15 the up- and down-ramp shape PA_{DAC} using the corrected highest value of the up- and down-ramp PA_{DAC,MAX}. The setting means 112 pass this the up- and down-ramp shape PA_{DAC} to the transmitter 102 which then in step L17 transmits the signal S_{IN} using the up- and down-ramp shape PA_{DAC}.

As already discussed, the output power P_{OUT} is dependent on various parameters. The loop described with reference to Figure 3 selects a correct correction parameter.

When a non-constant envelope modulation scheme, such as 8PSK, is used, information is carried in both the phase and the amplitude of the signal. Therefore the signal will be distorted if the amplitude in any way is changed while transmitting a burst. The ramping changes the amplitude outside the data information in the burst. This means that the ramping procedure/correction is the same; the ramp is scaled to fit to the corrected output power, which is demanded by the network.

Figure 4 illustrates a flow diagram describing how the power control can be made adjustable in accordance with the present invention. In step L21, the detected power level P_{A} is measured by the power level detection means 104. The detected power level P_{A} represents that the signal S_{OUT} is being transmitted with a power P_{OUT}.

In step L23 the comparing means 262 compare the detected power level P_{A} with the target power level P_{T} which has been obtained from the signalling unit.

In step L25 it is checked whether the detected power level P_{A} is acceptable: the comparison result Δ_{PL} obtained from the comparing means 262 is compared in the estimating means 266 against a predefined threshold value.

If the predetermined threshold value is not exceeded, that is, if the detected power level P_{A} is acceptable the correction loop returns to the beginning i.e. to step L21 and continues with obtaining a new detected power level P_{A} for a subsequent part of some other coming data burst.

In the opposite case, that is, if in step L25 it is detected that the detected power level P_{A} is not acceptable, the estimating means 266 estimates in step L27 a new correction parameter NEW Δ_{PA}. As discussed above, this new correction parameter NEW Δ_{PA} may also be a function of channel frequency CH, temperature T, and supply voltage VACC. In the step L28 the new correction parameter NEW Δ_{PA} is stored by the storing means 130 to the data storage 110. When the new correction parameter NEW Δ_{PA} has been stored in step L28, the adjusting loop begins again at step L 21.

The difference between the corrected output power and the ramp height is non-existent when the ramp has been scaled to fit. For example, a raised cosine wave form can easily be scaled.

Correspondingly, the history data storage 210 may be used for storing a history showing the evolution of this relationship spanned over discrete set of changes in the parameter {T, VACC, CH} space.

As can be noted from the description above, the power level correction system itself is a self-learning system instead of the prior art solutions using fixed correction values.

Figure 7 shows how up- and down-ramp shapes change by different modulations. In Figure 7 are both GMSK and 8-PSK modulations illustrated. The output power decreases at the down ramp phase.

To summarise, according to one embodiment of a system according to the present invention, an input signal is transmitted using an up- and down-ramp, wherein the output signal should have a predetermined output power level.

The power level for the output signal is estimated from a table look-up fixed by frequency, temperature and supply voltage, for example. Further, a correction value is selected from data storage means wherein correction values for the up- and down-ramp of the transmitting means are stored. There may be different up- and down-ramps for different output powers that are scaled to fit the corrected output power. Preferably, the selecting means are adapted to use in the selection the value describing the combination with at least one of the following i) temperature, ii) supply voltage, or iii) channel frequency.

The up- and down-ramp used in the transmitting means is corrected with the correction parameter selected. Further, the output power level is detected and a detected power level is compared with a target power level. If the result of the comparison shows that the power level detected differs from the target power level more than a predetermined threshold value, a new correction parameter is estimated and then stored into the data storage means.

According to this embodiment, the old correction parameter is read from the data storage means and then used in calculating the new correction parameter. Also the difference between the target power level and the detected power level may be used in the calculation.

Further, a value describing the relationship between a power level and an up- and down-ramp is read from a history data storage. This value is then used for estimating the new correction value. Correspondingly, the system includes a history data storage into which values describing the relationship between the power level measured and the up- and down-ramp are stored.

The transmitter may employ one or more of the variety of transmission techniques for the radio frequency interface such as AMFM, PSK, QPSK, 8-PSK, X-PSK, X-QAM (X=1,2,3,4,5....), TDMA, CDMA, or other techniques, such as constituted by an optical interface like infrared or low-power infrared.

It is to be noted that the invention suits especially well for both constant envelope and non-constant envelope modulation schemes, for example those used in the mobile networks, such as in the Universal Mobile Telecommunication System UMTS, or the Enhanced Data rates for GSM Evolution EDGE networks. Similarly, it may be used in both mobile terminals and base stations.

### List of symbols and references used

- **102**: transmitter
- **104**: power level detection means
- **108**: selecting means
- **110**: data storage
- **112**: setting means
- **120**: correction changing means
- **125**: reading means
- **130**: storing means
- **160**: correction means
- **180**: power level estimating means
- **210**: history data storage
- **225**: reading means
- **230**: storing means
- **262**: comparing means
- **266**: estimating means

- **CH**: channel frequency
- **Pᵢₙ**: input power
- **Pₒᵤₜ**: output power
- **P_{A}**: detected power level
- **Δ_{PA}**: correction parameter
- **P_{T}**: target power level
- **Δ_{PL}**: comparison result
- **PA_{DAC}**: up- and down-ramp shape
- **PA_{DAC, MAX}**: maximum estimated power level
- **NEW Δ_{PA}**: new correction parameter
- **OLD Δ_{PA}**: old correction parameter
- **S_{IN}**: input signal
- **Sₒᵤₜ**: output signal
- **T**: temperature
- **VACC**: supply voltage

## Claims

1. A power control system for a radio transmitter, including:
- a transmitter (102) for receiving and amplifyng an input signal (S_{IN}) and producing therefrom an output signal (S_{OUT}) using an up-down-ramp shape (PA_{DAC}) having an output power level (P_{OUT});
- correction means (160) for correcting the operation of the transmitter (102) by correcting the output power of the transmitter (102), with a correction parameter (Δ_{PA}) stored in a data storage (110), said correction effected by said correction means (160) includes an correction of the up- and down-ramp shape (PA_{DAC}) used in the transmitting step (L17) by the correction parameter (Δ_{PA}), the correction causing a change in the output power level (P_{OUT});
- power level detection means (104), for detecting a power level (P_{A}) representing the output power (P_{OUT}) of the transmitted signal (S_{OUT});
- comparing means (262) adapted to compare said detected power level (P_{A}) with a target power level (P_{T}) thus producing comparison result (Δ_{PL});
- estimating means (266) responsive to the comparing means (262), adapted to estimate a new correction parameter (NEW Δ_{PA}) if the comparison result (Δ_{PL}) shows that the detected power level (P_{A}) measured differs from the target power level (P_{T}) more than a predetermined threshold value; and
- storing means (130) adapted to store the new correction parameter (NEW Δ_{PA}) into the data storage (110),
**characterized in that** the system further includes:
- reading means (225) for reading a value describing a relationship between a power level (P_{L}) and an up- and down-ramp shape (PA_{DAC}) from a history data storage (210);
- storing means (230) for storing a value describing a relationship between the power level detected (PA) and the up- and down-ramp shape (PA_{DAC}) into the history data storage (210),
and wherein:
- the estimating means (266) are adapted to use also the value describing the relationship between a power level (P_{L}) and an up- and down-ramp shape (PA_{DAC}) read in calculating the new correction parameter (NEW Δ_{AP}).

2. A system according to claim 1,
wherein said correction parameter (Δ_{PA}) depends on at least on one of the following: i) temperature (T), ii) channel frequency (CH), and iii) supply voltage (VACC).

3. A system according to claim 1 or 2,
wherein the system further includes:
- reading means (125) for reading a stored correction parameter (OLD Δ_{PA}) from the data storage (110); and
wherein:
- the estimating means (266) are adapted to calculate the new correction parameter (NEW Δ_{PA}) based on the correction parameter (OLD Δ_{PA}) read from the data storage (110), and the difference (Δ_{PL}) between predefined power level (P_{T}) and detected power level (P_{A}).

4. A system according to one of claims 1 to 3,
wherein the correction means (160) are further adapted to fit ramping of the transmitter (102) to the corrected output power, thus making burst to burst output power and ramping correction.

5. A mobile terminal or a base station,
wherein a power control system according to one of claims 1 to 4 is used.

6. A power control method for a radio transmitter, the method including the steps of:
- transmitting (L17) and amplifying an input signal (S_{IN}) into an output signal, said output signal (S_{OUT}) using an up- and down-ramp shape (PA_{DAC}), and having an output power level (P_{OUT}), said transmitting step includes the step of correcting (L13) the output power of the transmission by a previously stored correction parameter (Δ_{PA}), said correcting (L13) includes correcting the up- and down-ramp shape (PA_{DAC}) used in the transmitting step (L17) by the correction parameter (Δ_{PA}) ;
- detecting (L21) a power level (P_{A}) of the output signal;
- comparing (L23) the detected power (P_{A}) with a target power level (P_{T});
- estimating (L27) a new correction parameter (NEW Δ_{PA}) if the result of the comparing step shows that the power level (P_{A}) detected differs from the target power level (P_{T}) more than a predetermined threshold value; and
- storing (L28) said new correction parameter (NEW Δ_{PA}) for use in said correcting step (L13):
**characterized in that** the method further includes the steps of:
- reading a value describing a relationship between a power level (P_{L}) and an up- and down-ramp shape (PA_{DAC})
- storing a value describing a relationship between the power level detected (P_{A}) and the up- and down-ramp shape (PA_{DAC}).
and wherein:
- in the estimating step (L27) also the value describing the relationship between a power level (P_{L}) and an up- and down-ramp shape (PA_{DAC}) read is used in calculating the new correction parameter (NEW Δ_{PA}).

7. The method according to claim 6,
wherein said correction parameter (Δ_{PA}) depends on at least on one of the following: i) temperature (T), ii) channel frequency (CH), and iii) supply voltage (VACC).

8. A method according to one of claims 6 of 7,
wherein the method further includes the step of:
- reading a stored correction parameter (OLD Δ_{PA}); and
wherein:
- in the estimating step (L27) a new correction parameter (NEW Δ_{PA}) is calculated based on the correction parameter (OLD Δ_{PA}) read, and the difference (Δ_{PL}) between the predefined power level (P_{T}) and the detected power level (P_{A}).

9. A method according to one of claims 6 to 9,
wherein the ramping is scaled to fit the corrected output power.

10. A method according to one of claims 6 to 10,
wherein the method is used in a mobile terminal or in a base station.

## Patentansprüche

1. Leistungsregelsystem für einen Funksender, der Folgendes umfasst:
- einen Sender (102) zum Empfangen und Verstärken eines Eingangssignals (S_{IN}) und zum Erzeugen eines Ausgangssignals (S_{OUT}) davon unter Verwendung einer Auf- und Abwärtsrampenform (PA_{DAC}) mit einem Ausgangsleistungspegel (P_{OUT});
- ein Korrekturmittel (160) zum Korrigieren des Betriebs des Senders (102) durch Korrigieren der Ausgangsleistung des Senders (102) mit einem in einem Datenspeicher (110) gespeicherten Korrekturparameter (Δ_{PA}), wobei die von dem genannten Korrekturmittel (160) bewirkte genannte Korrektur eine Korrektur der im Sendeschritt (L17) verwendeten Auf- und Abwärtsrampenform (PA_{DAC}) um den Korrekturparameter (Δ_{PA}) beinhaltet, wobei die Korrektur eine Änderung des Ausgangsleistungspegels (P_{OUT}) bewirkt;
- ein Leistungspegelerfassungsmittel (104) zum Erfassen eines Leistungspegels (P_{A}), der die Ausgangsleistung (P_{OUT}) des gesendeten Signals (S_{OUT}) repräsentiert;
- ein Vergleichsmittel (262) zum Vergleichen des genannten erfassten Leistungspegels (P_{A}) mit einem Zielleistungspegel (P_{T}), um ein Vergleichsergebnis (Δ_{PL}) zu erzeugen;
- ein Schätzmittel (266), das auf das Vergleichsmittel (262) anspricht und die Aufgabe hat, einen neuen Korrekturparameter (NEW Δ_{PA}) zu schätzen, wenn das Vergleichsergebnis 1 (Δ_{PL}) zeigt, dass sich der gemessene erfasste Leistungspegel (P_{A}) um Vergleichsergebnis (Δ_{PL}) zeigt, dass sich der gemessene erfasste Leistungspegel (P_{A}) zum mehr als einen vorbestimmten Schwellenwert vom Zielleistungspegel (P_{T}) unterscheidet; und
- ein Speichermittel (130) zum Speichern des neuen Korrekturparameters (NEW Δ_{PA}) im Datenspeicher (110),
**dadurch gekennzeichnet, dass** das System ferner Folgendes beinhaltet:
- ein Lesemittel (225) zum Lesen eines Wertes, der ein Verhältnis zwischen einem Leistungspegel (P_{L}) und einer Auf und Abwärtsrampenform (PA_{DAC}) aus einem Historiendatenspeicher (210) beschreibt;
- ein Speichermittel (230) zum Speichern eines Wertes, der ein Verhältnis zwischen dem erfassten Leistungspegel (PA) und der Auf- und Abwärtsrampenform (PA_{DAC}) beschreibt, im Historiendatenspeicher (210), und wobei:
- das Schätzmittel (266) die Aufgabe hat, auch den Wert, der das Verhältnis zwischen einem Leistungspegel (P_{L}) und einer gelesenen Auf- und Abwärtsrampenform (PA_{DAC}) beschreibt, beim Berechnen des neuen Korrekturparameters (NEW Δ_{PA}) zu benutzen.

2. System nach Anspruch 1, wobei der genannte Korrekturparameter (Δ_{PA}) von wenigstens einem der folgenden Faktoren abhängig ist: i) Temperatur (T), ii) Kanalfrequenz (CH) und iii) Speisespannung (VACC).

3. System nach Anspruch 1 oder 2, wobei das System ferner Folgendes beinhaltet:
- ein Lesemittel (125) zum Lesen eines gespeicherten Korrekturparameters (OLD Δ_{PA}) aus dem Datenspeicher (110); und wobei:
- das Schätzmittel (266) die Aufgabe hat, den neuen Korrekturparameter (NEW Δ_{PA}) auf der Basis des aus dem Datenspeicher (110) gelesenen Korrekturparameters (OLD Δ_{PA}) und der Differenz (Δ_{PL}) zwischen dem vordefinierten Leistungspegel (P_{T}) und dem erfassten Leistungspegel (P_{A}) zu berechnen.

4. System nach einem der Ansprüche 1 bis 3, wobei das Korrekturmittel (160) ferner die Aufgabe hat, die Rampenform des Senders (102) an die korrigierte Ausgangsleistung anzupassen, so dass eine Ausgangsleistungs- und Rampenformkorrektur von Bündel zu Bündel erfolgt.

5. Mobilterminal oder Basisstation, wobei ein Leistungsregelsystem nach einem der Ansprüche 1 bis 4 verwendet wird.

6. Leistungsregelverfahren für einen Funksender, wobei das Verfahren die folgenden Schritte beinhaltet:
- Senden (L17) eines Eingangssignals (S_{IN}) und Verstärken desselben zu einem Ausgangssignal, wobei das genannte Ausgangssignal (S_{OUT}) eine Auf- und Abwärtsrampenform (PA_{DAC}) verwendet und einen Ausgangsleistungspegel (P_{OUT}) hat, wobei der genannte Sendeschritt den Schritt des Korrigierens (L13) der Ausgangsleistung der Sendung mit einem zuvor gespeicherten Korrekturparameter (Δ_{PA}) beinhaltet, wobei die genannte Korrektur (L13) das Korrigieren der im Sendeschritt (L17) verwendeten Auf- und Abwärtsrampenform (PA_{DAC}) um den Korrekturparameter (Δ_{PA}) beinhaltet;
- Erfassen (L21) eines Leistungspegels (P_{A}) des Ausgangssignals;
- Vergleichen (L23) der erfassten Leistung (P_{A}) mit einem Zielleistungspegel (P_{T});
- Schätzen (L27) eines neuen Korrekturparameters (NEW Δ_{PA}), wenn das Ergebnis des Vergleichsschrittes zeigt, dass sich der erfasste Leistungspegel (P_{A}) vom Zielleistungspegel (P_{T}) um mehr als einen vorbestimmten Schwellenwert unterscheidet; und
- Speichern (L28) des genannten neuen Korrekturparameters (NEW Δ_{PA}) für die Verwendung in dem genannten Korrekturschritt (L13);
**dadurch gekennzeichnet, dass** das Verfahren ferner die folgenden Schritte beinhaltet:
- Lesen eines Wertes, der ein Verhältnis zwischen einem Leistungspegel (P_{L}) und einer Auf- und Abwärtsrampenform (PA_{DAC}) beschreibt;
- Speichern eines Wertes, der ein Verhältnis zwischen dem erfassten Leistungspegel (P_{A}) und der Auf- und Abwärtsrampenform (PA_{DAC}) beschreibt;
und wobei:
- in dem Schätzschritt (L27) auch der Wert, der das Verhältnis zwischen einem Leistungspegel (P_{L}) und einer gelesenen Auf- und Abwärtsrampenform (PA_{DAC}) beschreibt, beim Berechnen des neuen Korrekturparameters (NEW Δ_{PA}) verwendet wird.

7. Verfahren nach Anspruch 6, wobei der genannte Korrekturparameter (Δ_{PA}) wenigstens von einem der folgenden Faktoren abhängig ist: i) Temperatur (T), ii) Kanalfrequenz (CH) und iii) Speisespannung (VACC).

8. Verfahren nach Anspruch 6 oder 7, wobei das Verfahren ferner den folgenden Schritt beinhaltet:
- Lesen eines gespeicherten Korrekturparameters (OLD Δ_{PA}); und wobei:
- in dem Schätzschritt (L27) ein neuer Korrekturparameter (NEW Δ_{PA}) auf der Basis des gelesenen Korrekturparameters (OLD Δ_{PA}) und der Differenz (Δ_{PL}) zwischen dem vordefinierten Leistungspegels (P_{T}) und dem erfassten Leistungspegel (P_{A}) berechnet wird.

9. Verfahren nach einem der Ansprüche 6 bis 9 [*sic*]*,* wobei die Rampenform so skaliert wird, dass sie zu der korrigierten Ausgangsleistung passt.

10. Verfahren nach einem der Ansprüche 6 bis 10 [*sic*], wobei das Verfahren in einem Mobilterminal oder in einer Basisstation angewendet wird.

## Revendications

1. Système de commande de puissance pour émetteur radio, comportant :
- un émetteur (102) pour recevoir et amplifier un signal d'entrée (S_{IN}) et produire à partir de celui-ci un signal de sortie (S_{OUT}) utilisant une forme de rampe montante et descendante (PA_{DAC}) ayant un niveau de puissance de sortie (P_{OUT}) ;
- des moyens de correction (160) pour corriger le fonctionnement de l'émetteur (102) en corrigeant la puissance de sortie de l'émetteur (102), avec un paramètre de correction (Δ_{PA}) mémorisé dans une mémoire de données (110), ladite correction effectuée par lesdits moyens de correction (160) comporte une correction de la forme de rampe montante et descendante (PA_{DAC}) utilisée dans l'étape d'émission (L17) par le paramètre de correction (Δ_{PA}), la correction entraînant un changement du niveau de puissance de sortie (P_{OUT}) ;
- des moyens de détection de niveau de puissance (104), pour détecter un niveau de puissance (P_{A}) représentant la puissance de sortie (P_{OUT}) du signal émis (S_{OUT}) ;
- des moyens de comparaison (262) adaptés pour comparer ledit niveau de puissance détecté (P_{A}) à un niveau de puissance cible (P_{T}) produisant ainsi un résultat de comparaison (Δ_{PL}) ;
- des moyens d'estimation (266) sensibles aux moyens de comparaison (262), adaptés pour estimer un nouveau paramètre de correction (NOUVEAU Δ_{PA}) si le résultat de comparaison (Δ_{PL}) montre que le niveau de puissance détecté (P_{A}) mesuré diffère du niveau de puissance cible (P_{T}) par plus d'une valeur de seuil prédéterminée ; et
- des moyens de mémorisation (130) adaptés pour mémoriser le nouveau paramètre de correction (NOUVEAU Δ_{PA}) dans la mémoire de données (110),
**caractérisé en ce que** le système comporte en outre :
- des moyens de lecture (225) pour lire une valeur décrivant une relation entre un niveau de puissance (P_{L}) et une forme de rampe montante et descendante (PA_{DAC}) dans une mémoire de données historiques (210) ;
- des moyens de mémorisation (230) pour mémoriser une valeur décrivant une relation entre le niveau de puissance détecté (P_{A}) et la forme de rampe montante et descendante (PA_{DAC}) dans la mémoire de données historiques (210),
et dans lequel :
- les moyens d'estimation (266) sont adaptés pour utiliser également la valeur décrivant la relation entre un niveau de puissance (P_{L}) et une forme de rampe montante et descendante (PA_{DAC}) lue dans le calcul du nouveau paramètre de correction (NOUVEAU Δ_{PA}).

2. Système selon la revendication 1,
dans lequel ledit paramètre de correction (Δ_{PA}) dépend d'au moins l'un des facteurs suivants : i) température (T), ii) fréquence de canal (CH), et iii) tension d'alimentation (VACC).

3. Système selon la revendication 1 ou 2,
dans lequel le système comporte en outre :
- un moyen de lecture (125) pour lire un paramètre de correction mémorisé (ANCIEN Δ_{PA}) dans la mémoire de données (110) ; et
dans lequel :
- les moyens d'estimation (266) sont adaptés pour calculer le nouveau paramètre de correction (NOUVEAU Δ_{PA}) d'après le paramètre de correction (ANCIEN Δ_{PA}) lu dans la mémoire de données (110), et la différence (Δ_{PL}) entre le niveau de puissance prédéfini (P_{T}) et le niveau de puissance détecté (P_{A}).

4. Système selon l'une quelconque des revendications 1 à 3,
dans lequel les moyens de correction (160) sont adaptés en outre pour ajuster la rampe de l'émetteur (102) sur le niveau de puissance corrigé, effectuant ainsi une correction de puissance de sortie et de rampe d'une salve à une autre.

5. Terminal mobile ou station de base,
dans lequel un système de commande de puissance selon l'une quelconque des revendications 1 à 4 est utilisé.

6. Procédé de commande de puissance pour émetteur radio, le procédé comportant les étapes suivantes :
- émission (L17) et amplification d'un signal d'entrée (S_{IN}) en un signal de sortie , ledit signal de sortie (S_{OUT}) utilisant une forme de rampe montante et descendante (PA_{DAC}) et ayant un niveau de puissance de sortie (P_{OUT}) ;ladite étape d'émission comporte l'étape de correction (L13) de la puissance de sortie de l'émission par un paramètre de correction (Δ_{PA}) précédemment mémorisé, ladite correction (L13) comporte la correction de la forme de rampe montante et descendante (PA_{DAC}) utilisée dans l'étape d'émission (L17) par le paramètre de correction (Δ_{PA}) ;
- détection (L21) d'un niveau de puissance (P_{A}) du signal de sortie ;
- comparaison (L23) de la puissance détectée (P_{A}) à un niveau de puissance cible (P_{T}) ;
- estimation (L27) d'un nouveau paramètre de correction (NOUVEAU Δ_{PA)} si le résultat de l'étape de comparaison montre que le niveau de puissance (P_{A}) détecté diffère du niveau de puissance cible (P_{T}) par plus d'une valeur de seuil prédéterminée ; et
- mémorisation (L28) dudit nouveau paramètre de correction (NOUVEAU Δ_{PA}) en vue de son utilisation dans ladite étape de correction (L13) ;
**caractérisé en ce que** le procédé comporte en outre les étapes suivantes :
- lecture d'une valeur décrivant une relation entre un niveau de puissance (P_{L}) et une forme de rampe montante et descendante (PA_{DAC}) ;
- mémorisation d'une valeur décrivant une relation entre le niveau de puissance détecté (P_{A}) et la forme de rampe montante et descendante (PA_{DAC}) ;
et dans lequel :
- dans l'étape d'estimation (L27) la valeur décrivant la relation entre un niveau de puissance (P_{L}) et une forme de rampe montante et descendante (PA_{DAC}) lue est aussi utilisée dans le calcul du nouveau paramètre de correction (NOUVEAU Δ_{PA}).

7. Procédé selon la revendication 6,
dans lequel ledit paramètre de correction (Δ_{PA}) dépend d'au moins l'un des facteurs suivants : i) température (T), ii) fréquence de canal (CH), et iii) tension d'alimentation (VACC).

8. Procédé selon la revendication 6 ou 7,
dans lequel le procédé comporte en outre l'étape suivante :
- lecture d'un paramètre de correction mémorisé (ANCIEN Δ_{PA}) ; et dans lequel :
- dans l'étape d'estimation (L27) un nouveau paramètre de correction (NOUVEAU Δ_{PA}) est calculé d'après le paramètre de correction (ANCIEN Δ_{PA}) lu, et la différence (Δ_{PL}) entre le niveau de puissance prédéfini (P_{T}) et le niveau de puissance détecté (P_{A}).

9. Procédé selon l'une quelconque des revendications 6 à 9 [*sic*]*,*
dans lequel la rampe est dimensionnée pour correspondre à la puissance de sortie corrigée.

10. Procédé selon l'une quelconque des revendications 6 à 10 [*sic*],
dans lequel le procédé est utilisé dans un terminal mobile ou dans une station de base.
